(19) Europäisches Patentamt
European Patent Office
Office européen des brevets

(11) **EP 3 291 138 A1**

(12) **EUROPEAN PATENT APPLICATION**

(43) Date of publication:
**07.03.2018 Bulletin 2018/10**

(51) Int Cl.:
***G06K 9/00*** *(2006.01)* ***G01S 17/02*** *(2006.01)*
***G01S 17/93*** *(2006.01)* ***B60W 30/12*** *(2006.01)*

(21) Application number: **17187303.7**

(22) Date of filing: **22.08.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **02.09.2016 US 201615255737**

(71) Applicant: **Delphi Technologies, Inc.**
**Troy, MI 48007-5052 (US)**

(72) Inventors:
• **SCHIFFMANN, Jan K.**
**Newbury Park, California 91320 (US)**
• **SCHWARTZ, David A.**
**Moorpark, California 90265 (US)**

(74) Representative: **Robert, Vincent et al**
**Delphi France SAS**
**Bâtiment Le Raspail - Paris Nord 2**
**22, avenue des Nations**
**CS 65059 Villepinte**
**95972 Roissy CDG Cedex (FR)**

(54) **AUTOMATED-VEHICLE 3D ROAD-MODEL AND LANE-MARKING DEFINITION SYSTEM**

(57) A road-model-definition system (10) suitable for an automated-vehicle includes a camera (14), a lidar-unit (20), and a controller (24). The camera (14) used is to provide an image (16) of an area (18) proximate to a host-vehicle (12). The lidar-unit (20) is used to provide a point-cloud (22) descriptive of the area (18). The controller (24) is in communication with the camera (14) and the lidar-unit (20). The controller (24) is configured to determine an image-position (28) of a lane-marking (26) in the image (16), select ground-points (44) from the point-cloud (22) indicative of a travel-surface (42), determine coefficients of a three-dimensional (3D) road-model (40) based on the ground-points (44), and determine a transformation (60) to map the lane-marking (26) in the image (16) onto the travel-surface (42) based on the image-position (28) of a lane-marking (26) and the 3D road-model (40) and thereby obtain a 3D marking-model.

FIG. 1

**Description**

**TECHNICAL FIELD OF INVENTION**

his disclosure generally relates to a road-model-definition system, and more particularly relates to a system that determines a transformation used to map a lane-marking present in an image from a camera onto a travel-surface model that is based on lidar data to obtain a 3D marking-model of the lane-marking.

**BACKGROUND OF INVENTION**

An accurate model of the upcoming travel-surface (e.g. a roadway) in front of a host-vehicle is needed for good performance of various systems used in automated vehicles including, for example, an autonomous vehicle. It is known to model lane-markings of a travel-surface under the assumption that the travel-surface is planar, i.e. flat and level. However, the travel-surface is actually frequently crowned, meaning that the elevation of the travel-surface decreases toward the road-edge which is good for drainage during rainy conditions. Also, there is frequently a vertical curvature component which is related to the change in pitch angle of the travel-surface (e.g. turning up-hill or down-hill) as the host-vehicle moves along the travel-surface. Under these non-planar conditions, lane-marking estimates from a vision system that assumes a planar travel-surface leads to an inadequately accurate road-model. The travel-surface may also be banked, or inclined, for higher speed turns such as freeway exits, which while planar, is important for vehicle control.

**SUMMARY OF THE INVENTION**

Described herein is a road-model-definition system that uses an improved technique for obtaining a three-dimensional (3D) model of a travel-lane using a lidar and a camera. The 3D road-model incorporates the components of crown and vertical curvature of a travel-surface, along with vertical and/or horizontal curvature of a lane-marking detected in an image from the camera. The 3D model permits more accurate estimation of pertinent features of the environment, e.g. the position of preceding vehicles relative to the travel-lane, and more accurate control of a host-vehicle in an automated driving setting, e.g. better informing the steering controller of the 3D shape of the travel-lane.

In accordance with one embodiment, a road-model-definition system suitable for an automated-vehicle is provided. The system includes a camera, a lidar-unit, and a controller. The camera used is to provide an image of an area proximate to a host-vehicle. The lidar-unit is used to provide a point-cloud descriptive of the area. The controller is in communication with the camera and the lidar-unit. The controller is configured to determine an image-position of a lane-marking in the image, select ground-points from the point-cloud indicative of a travel-surface, determine coefficients of a three-dimensional (3D) road-model based on the ground-points, and determine a transformation to map the lane-marking in the image onto the travel-surface based on the image-position of a lane-marking and the 3D road-model and thereby obtain a 3D marking-model.

The ground-points may be those from the point-cloud characterized with a height-value less than a height-threshold. The 3D road-model may be derived from a polynomial-model of the ground-points. The 3D road-model may correspond to a bi-quadratic-model of the polynomial-model. The 3D road-model may characterize the lane-marking using two 2D cubic-polynomials based on a horizontal-curvature and a vertical-curvature of the lane-marking.

Further features and advantages will appear more clearly on a reading of the following detailed description of the preferred embodiment, which is given by way of non-limiting example only and with reference to the accompanying drawings.

**BRIEF DESCRIPTION OF DRAWINGS**

The present invention will now be described, by way of example with reference to the accompanying drawings, in which:

Fig. 1 is a diagram of road-model-definition system in accordance with one embodiment;
Fig. 2 is an image of captured by the system of Fig. 1 in accordance with one embodiment;
Fig. 3 is a graph of data used by the system of Fig. 1 in accordance with one embodiment;
Fig. 4 is a graph of a 3D model determined by the system of Fig. 1 in accordance with one embodiment; and
Fig. 5 is another graph of a 3D model determined by the system of Fig. 1 in accordance with one embodiment.

**DETAILED DESCRIPTION**

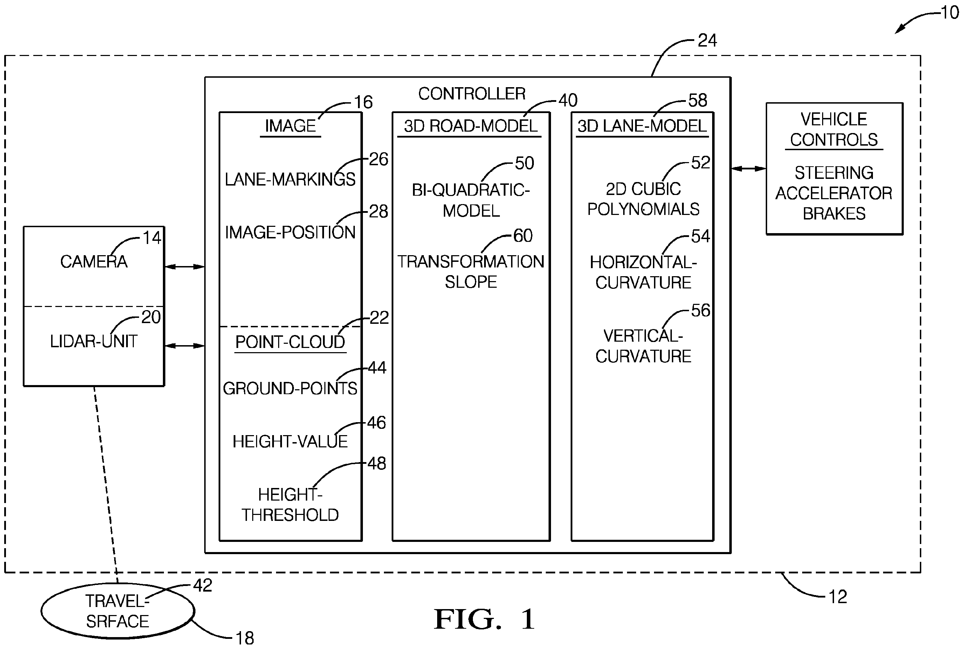

Fig. 1 illustrates a non-limiting example of a road-model-definition system 10, hereafter referred to as the system 10, which is suitable for use by an automated-vehicle, e.g. a host-vehicle 12. While the examples presented may be characterized as being generally directed to instances when the host-vehicle 12 is being operated in an automated-mode, i.e. a fully autonomous mode, where a human operator (not shown) of the host-vehicle 12 does little more than designate a destination to operate the host-vehicle 12, it is contemplated that the teachings presented herein are useful when the host-vehicle 12 is operated in a manual-mode. While in the manual-mode the degree or level of automation may be little more than providing steering assistance to the human operator who is generally in control of the steering, accelerator, and brakes of the host-vehicle 12. That is, the system 10 may only assist the human operator as needed to keep the host-vehicle 12 centered in a travel-lane, maintain control of the host-vehicle 12, and/or avoid interference and/or a collision with, for example, another vehicle.

The system 10 includes, but is not limited to, a camera 14 used to provide an image 16 of an area 18 proximate to a host-vehicle 12, and a lidar-unit 20 used to provide a point-cloud 22 (i.e. a collection of coordinates of lidar detected points, as will be recognized by those in the art) descriptive of the area 18. While the camera 14 and the lidar-unit 20 are illustrated in a way that suggests that they are co-located, possibly in a single integrated unit, this is not a requirement. It is recognized that co-location would simplify aligning the image 16 and the point-cloud 22. However, several techniques are known for making such an alignment of data when the camera 14 and the lidar-unit 20 are located on the host-vehicle 12 at spaced-apart locations. It also not a requirement that the fields-of-view of the camera 14 and the lidar-unit 20 are identical. That is, for example, the camera 14 may have a wider-field-of view than the lidar-unit, but both fields-of-view include or cover the area 18, which may be generally characterized as forward of the host-vehicle 12.

The system 10 includes a controller 24 in communication with the camera 14 and the lidar-unit 20. The controller 24 may include a processor (not specifically shown) such as a microprocessor and/or other control circuitry such as analog and/or digital control circuitry including an application specific integrated circuit (ASIC) for processing data as should be evident to those in the art. The controller 24 may include memory (not specifically shown), including nonvolatile memory, such as electrically erasable programmable read-only memory (EEPROM) for storing one or more routines, thresholds, and captured data. The one or more routines may be executed by the processor to perform steps for determining a 3D model of the area 18 about the host-vehicle 12 based on signals received by the controller 24 from the camera 14 and the lidar-unit 20, as described in more detail elsewhere herein.

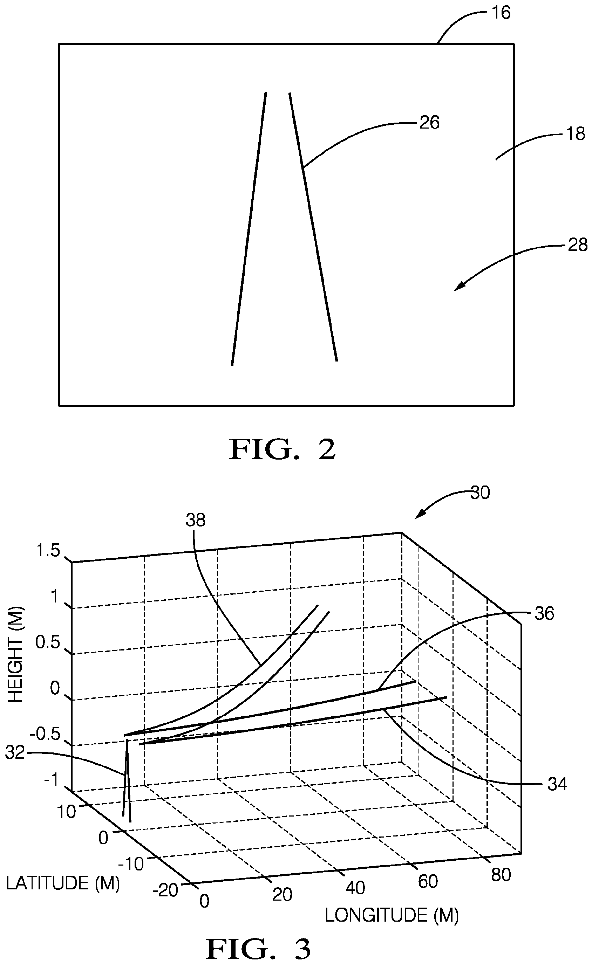

Fig. 2 illustrates a non-limiting example of the image 16 captured or provided by the camera 14 which includes or shows a lane-marking 26. As will be recognized by those in the art, the end of the lane-marking 26 at the bottom of the image 16 is relatively close to the host-vehicle 12, and the end at the top is relatively distant from the host-vehicle 12. It is recognized that many other details and features of, for example, other objects present in the area 18 may be present in the image 16, but they are not shown in Fig. 2 only to simplify the illustration. It is also recognized that there will likely be additional instances of lane-markings in the image that are not shown, and that the lane-marking 26 may be something other than a solid (i.e. continuous) line, e.g. a dashed line, or a combination of dashed and solid lines.

The controller 24 is configured to determine an image-position 28 of a lane-marking 26 in the image 16. By way of example and not limitation, it may be convenient to indicate the image-position 28 of the lane-marking 26 by forming a list of pixels or coordinates where the lane-marking 26 is detected in the image 16. The list may be organized in terms of the i-th instance where, for each lane marker, the lane-marking 26 is detected and that list may be described by

$$L(i) = [u(i), v(i)] \quad \text{for } i = 1{:}N \qquad \text{Eq. 1,}$$

where $u(i)$ is the vertical-coordinate and $v(i)$ is the horizontal-coordinate for the i-th instance of coordinates indicative of the image-position 28 of the lane-marking 26 being detected in the image 16. If the camera 14 has a resolution of 1024 by 768 for a total of 786,432 pixels, the number of entries in the list may be unnecessarily large, i.e. the resolution may be unnecessarily fine. As one alternative, a common approach is to list the pixel position (u, v) of the center or mid-line of the detected lane marker, so the list would determine or form a line along the center or middle of the lane-marking 26. As another alternative, the pixels may be grouped into, for example, twelve pixels per pixel-group (e.g. four x three pixels), so the number of possible entries is 65,536 which for reduced capability instances of the controller 24 may be more manageable. It should be apparent that typically the lane-marking 26 occupies only a small fraction of the image 16. As such the actual number of pixels or pixel-groups where the lane-marking is detected will be much less than the total number of pixels or pixel-groups in the image 16. An i-th pixel or pixel-group may be designated as indicative of, or overlying, or corresponding to the lane-marking 26 when, for example, half or more than half of the pixels in a pixel-group indicates the presence of the lane-marking 26.

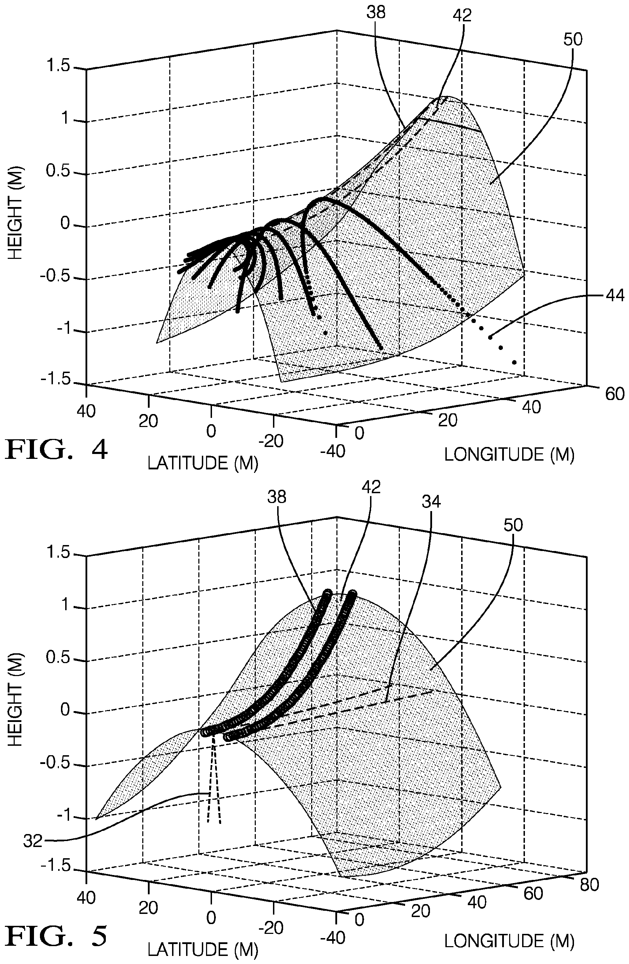

Fig. 3 illustrates a non-limiting example of graph 30 that illustrates the relationship between an imaged-marker 32 that corresponds to the lane-marking 26 in Fig. 2, a projected-marker 34 that corresponds to an inverse perspective projection of the imaged-marker 32 onto a zero-height-plane 36 established or defined by the tire contact areas of the host-vehicle 12, and a modeled-marker 38 that corresponds to a where the lane-markers 26 are located on a 3D-model (Fig. 4) of the area 18. At this point it should be recognized that the 3D-model of the area must be determined before the modeled-marker 38 can be determined by projecting the projected-marker 34 onto the 3D-model.

It has been observed that the difference between the true 3-D positions of lane-markers on a roadway and an assumed position that is based on a flat, zero height, ground plane can be significant in practice due to vertical-curvature (e.g. the roadway bending up-hill or down-hill), and/or horizontal curvature or inclination (road crowning, high speed exit ramps, etc.), which can lead to compromises with respect to precise control of the host-vehicle 12. For example, note that the lines of the projected-marker 34 are illustrated as diverging as the longitude value increases. This is because the actual roadway where the lane-marker actually resides is bending upward, i.e. has positive vertical-curvature. As such, when the imaged-marker 32 is projected onto the zero-height-plane 36 because a flat road is assumed, the lack of compensation for vertical-curvature causes the projected-marker 34 to diverge.

The projection of the imaged-marker 32 onto a 3D model of the roadway produces the modeled-marker 38, which may be performed by assuming an idealized pin-hole model for the camera 14, without assuming a loss of generality,. Assuming that the camera 14 is located at Cartesian coordinates (x, y, z) of [0, 0, hc], where hc is the height of the camera 14 above the travel-surface 42, and the camera 14 has a focal length of f, the pin-hole camera model projects a i-th pixel or pixel-group from (x, y, z) in relative world coordinates to (u, v) in image coordinates using

$$u(i) = f * \{z(i) - hc\} / x(i)$$

$$\text{Eq. 2,}$$

and

$$v(i) = f * y(i) / x(i)$$

$$\text{Eq. 3.}$$

Fig. 4 illustrates a non-limiting example of a three-dimensional (3D) road-model 40 of the area 18 (Fig. 1), in this instance a biquadratic model 50. The 3D road-model 40 is needed to help fit the modeled-marker 38 to a 3D model (Fig. 1) of the roadway, e.g. a travel-surface 42 that is a portion of the area 18. To distinguish those portions of the area 18 that are not suitable for travel by the host-vehicle 12 from those that are, i.e. distinguish on-road areas (which may include shoulders of a roadway) from off-road areas and objects that should be avoided, the controller 24 is configured to select ground-points 44 from the point-cloud 22 that are indicative of the travel-surface 42. Those in the art will recognize that there are many ways to select which of the ground-points 44 from the point-cloud 22 are likely indicative of the travel-surface 42. By way of example and not limitation, the ground-points 44 may be those from the point-cloud 22 that are characterized with a height-value 46 less than a height-threshold 48. The height-value 46 of each instance of a cloud-point that makes up the point-cloud 22 may be calculated from the range and elevation angle to the cloud-point indicated by the lidar-unit 20, as will be recognized by those in the art.

Once the ground-points 44 that define the travel-surface 42 are defined, the controller 24 is configured to determine the 3D road-model 40 of the travel-surface 42 based on the ground-points 44. Given a set of M lidar ground measurements, where r(k), φ(k), and θ(k) are the range, elevation angle and azimuth angle respectively of the kth lidar measurement, a road surface model can be fit to the measurements. Typical models include: plane, bi-linear, quadratic, bi-quadratic, cubic, and bi-cubic and may further be tessellated patches of such models. While a number of surface-functions are available to base the 3D road-model 40 upon, analysis suggests that it may be preferable if the 3D road-model corresponds to the biquadratic model 50 of the ground-points 44, which may be represented by

$$x(k) = r(k) * \cos[\varphi(k)] * \cos[\theta(k)]$$

$$y(k) = r(k) * \cos[\varphi(k)] * \sin[\theta(k)]$$

$$\text{Eq. 4,}$$

$$z(k) = r(k) * \sin[\varphi(k)] + hl$$

where 'hl' is the height of the lidar-unit 20 above the zero-height-plane 36. z(k) is determined using a biquadratic model

$$z(k) = a1 + a2*x(k) + a3*y(k) + a4*x(k)^\wedge 2 + a5*y(k)^\wedge 2 + a6*x(k)*y(k) +$$

$$a7*x(k)^\wedge 2*y(k) + a8*x(k)*y(k)^\wedge 2 + a9*x(k)^\wedge 2*y(k)^\wedge 2$$

Eq. 5,

where a9 is assumed to be zero (a9 = 0) in order to simplify the model. The 3D road-model 40 is then determined by an estimated set of coefficients, $\hat{a}$, for the model that best fits the measured data. A direct least squares solution is then given by:

$$\begin{bmatrix} z(1) \\ \vdots \\ z(M) \end{bmatrix} = \begin{bmatrix} 1 & \tilde{x}_1 & \tilde{y}_1 & \tilde{x}_1^2 & \tilde{y}_1^2 & \tilde{x}_1\tilde{y}_1 & \tilde{x}_1^2\tilde{y}_1 & \tilde{x}_1\tilde{y}_1^2 \\ \vdots & \vdots & \vdots & \vdots & \vdots & \vdots & \vdots & \vdots \\ 1 & \tilde{x}_M\tilde{y}_M & \tilde{x}_N^2\tilde{y}_M^2 & \tilde{x}_M\tilde{y}_M & \tilde{x}_M^2\tilde{y}_M & \tilde{x}_M\tilde{y}_M^2 \end{bmatrix} \begin{bmatrix} a1 \\ \vdots \\ a8 \end{bmatrix}$$

Eq. 6a,

or

$$\widetilde{Z} = F\widehat{A}$$

Eq. 6b,

or

$$\widehat{A} = F\backslash\widetilde{Z}$$

Eq. 6c.

Now given the lane marker position of the imaged-marker 32 in the camera image plane, and the 3D road-model 40 of the travel-surface 42, the two can be fused together to get the estimated 3-D positions of the lane marker point. This can be done by solving a non-linear equation of the camera projection model constrained by the 3D road-model 40. The preferred embodiment of the road model is the biquadratic model 50, given by equations Eq. 4, Eq. 5, and Eq. 6. In Eq. 7 below, the coefficients $\hat{a}_i$ are the coefficients that were estimated by solving Eq. 6. The points $(u_k, v_k)$ are the image plane, pixel, positions of detected lane markers. The corresponding world coordinates of the lane marker detections are then solved for x(k), y(k), z(k), i.e. $(x_k, y_k, z_k)$, where

$$\begin{bmatrix} u_k = f\frac{(z_k - h_C)}{x_k} \\ v_k = f\frac{y_k}{x_k} \\ z_k = \hat{a}_1 + \hat{a}_2 x_k + \hat{a}_3 y_k + \hat{a}_4 x_k^2 + \hat{a}_5 y_k^2 + \hat{a}_6 x_k y_k + \hat{a}_7 x_k^2 y_k + \hat{a}_8 x_k y_k^2 \end{bmatrix} \text{Eq. 7.}$$

The solution to this system of equations is a cubic-polynomial equation. This equation can be solved with a closed form solution for cubic-polynomials, by root finding methods, or by optimization techniques such as the secant method

$$\Big( (a_7 f^2 v_k + a_8 f v_k^2) z_k^3 + (-3 a_7 h_C f^2 v_k + a_4 u_k f^2 - 3 a_8 h_C f v_k^2 + a_6 u_k f v_k + a_5 u_k v_k^2) z_k^2 + (3 a_7 f^2 h_C^2 v_k - 2 a_4 4 f^2 h_C u_k + 3 a_8 f h_C^2 v_k^2 - 2 a_6 f h_C u_k v_k + a_2 f u_k^2 - 2 a_5 h_C u_k v_k^2 - u_k^3 + a_3 u_k^2 v_k) z_k + (-a_7 f^2 h_C^3 v_k + a_4 f^2 h_C^2 u_k - a_8 f h_C^3 v_k^2 + a_6 f h_C^2 u_k v_k - a_2 f h_C u_k^2 + a_5 h_C^2 u_k v_k^2 - a_3 h_C u_k^2 v_k + a_1 u_k^3) \Big) = 0 \qquad \text{Eq. 8.}$$

Solving Eq. 8 for $z_k$, $x_k$ and $y_k$ can then be solved to provide the fused/reconstructed 3-D positions of the lane markers

$$x_k = -f \frac{(h - z_k)}{u_k}$$
$$y_k = -v_k \frac{(h - z_k)}{u_k}$$

$$\text{Eq. 9.}$$

Referring again to Figs. 3 and 4, it should be understood that the modeled-marker 38 is comparable to a fused reconstruction of the projected-marker 34 with the 3D road-model which in this example is the biquadratic model 50. That is, the modeled-marker 38 corresponds to the actual or true lane marker positions.

Fig. 5 shows the biquadratic model 50, with the imaged-marker 32, the projected-marker 34, and the resulting fusion of the biquadratic model 50, and the projected-marker 34, which is a 3D lane model 58.

Given the positions of the projected-marker 34 from Eq. 8 and Eq. 9, the point for each lane marker can then be converted to a more compact representation of the curves. In a preferred embodiment each lane marker is represented with two 2-D cubic-polynomials 52 that independently model the horizontal and vertical curvatures. That is, the 3D road-model 40 characterizes the lane-marking 26 using two 2D cubic-polynomials 52 that are based on a horizontal-curvature 54 and a vertical-curvature 56 of the lane-marking 26. For example, given the 3-D reconstructed point of the left lane marker $\{x_k, y_k, z_k\}^{\text{left}}$, then the horizontal-curvature is represented by

$$\begin{bmatrix} \tilde{a}_0^{(H)} \\ \tilde{a}_1^{(H)} \\ \tilde{a}_2^{(H)} \\ \tilde{a}_3^{(H)} \end{bmatrix} = \begin{bmatrix} 1 & x_1 & x_1^2 & x_1^3 \\ \vdots & \vdots & \vdots & \vdots \\ 1 & x_N & x_N^2 & x_N^3 \end{bmatrix} \backslash \begin{bmatrix} y_1 \\ \vdots \\ y_N \end{bmatrix}$$

$$\text{Eq. 10,}$$

where

$$\check{y}^{(LH)} = \tilde{a}_0^{(LH)} + \tilde{a}_1^{(LH)} x + \tilde{a}_2^{(LH)} x^2 + \tilde{a}_3^{(LH)} x^3$$

$$\text{Eq. 11,}$$

and the vertical-curvature is represented by

$$\begin{bmatrix} \tilde{a}_0^{(V)} \\ \tilde{a}_1^{(V)} \\ \tilde{a}_2^{(V)} \\ \tilde{a}_3^{(V)} \end{bmatrix} = \begin{bmatrix} 1 \ x_1 \ x_1^2 \ x_1^3 \\ \vdots \ \vdots \ \vdots \ \vdots \\ 1 \ x_N x_N^2 x_N^3 \end{bmatrix} \setminus \begin{bmatrix} z_1 \\ \vdots \\ z_N \end{bmatrix}$$

Eq. 12,

where

$$\check{z}^{(LH)} = \tilde{a}_0^{(V)} + \tilde{a}_1^{(V)} x + \tilde{a}_2^{(V)} x^2 + \tilde{a}_3^{(V)} x^3$$

Eq. 13.

That is, the controller 24 is configured to determine a transformation 60 that maps the lane-marking 26 in the image 16 onto the travel-surface 42 based on the image-position 28 of a lane-marking 26 and the 3D road-model 40, and thereby obtain the 3D lane model 58.

Accordingly, a road-model-definition system (the system 10), a controller 24 for the system 10, and a method of operating the system 10 is provided. The system 10 provides for the fusing of an image 16 of a lane-marking 26 with a 3D road-model 40 of a travel-surface 42 to provide a 3D lane-model of the lane-marking 26 so that any substantive error caused by a horizontal-curvature 54 and/or a vertical-curvature 56 of the travel-surface 42 is accounted for rather than assume that the travel-surface 42 is flat.

While this invention has been described in terms of the preferred embodiments thereof, it is not intended to be so limited, but rather only to the extent set forth in the claims that follow.

**Claims**

1.    A road-model-definition system (10) suitable for an automated-vehicle, said system (10) comprising:

   a camera (14) used to provide an image (16) of an area (18) proximate to a host-vehicle (12);
   a lidar-unit (20) used to provide a point-cloud (22) descriptive of the area (18); and
   a controller (24) in communication with the camera (14) and the lidar-unit (20), said controller (24) configured to determine an image-position (28) of a lane-marking (26) in the image (16),
   select ground-points (44) from the point-cloud (22) indicative of a travel-surface (42),
   determine a three-dimensional (3D) road-model (40) of the travel-surface (42) based on the ground-points (44), and
   determine a transformation (60) that maps the lane-marking (26) in the image (16) onto the travel-surface (42) based on the image-position (28) of a lane-marking (26) and the 3D road-model (40) and thereby obtain a 3D lane-model.

2.    The system (10) in accordance with claim 1, wherein the ground-points (44) are those from the point-cloud (22) characterized with a height-value (46) less than a height-threshold (48).

3.    The system (10) according to any one of the preceding claims, wherein the 3D road-model (40) is derived from a polynomial-model of the ground-points (44).

4.    The system (10) in accordance with claim 3, wherein the 3D road-model (40) corresponds to a bi-quadratic-model of the polynomial-model.

5.    The system (10) according to any one of the preceding claims, wherein the 3D road-model (40) characterizes the lane-marking (26) using two 2D cubic-polynomials (52) based on a horizontal-curvature (54) and a vertical-curvature (56) of the lane-marking (26).

FIG. 1

EP 3 291 138 A1

**FIG. 2**

**FIG. 3**

FIG. 4

FIG. 5

Europäisches
Patentamt

European
Patent Office

Office européen
des brevets

# EUROPEAN SEARCH REPORT

Application Number

EP 17 18 7303

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SEUNGHAK SHIN ET AL: "Combinatorial approach for lane detection using image and LIDAR reflectance", 2015 12TH INTERNATIONAL CONFERENCE ON UBIQUITOUS ROBOTS AND AMBIENT INTELLIGENCE (URAI), IEEE, 28 October 2015 (2015-10-28), pages 485-487, XP032831187, DOI: 10.1109/URAI.2015.7358810 [retrieved on 2015-12-16] | 1-3 | INV. G06K9/00 G01S17/02 G01S17/93 B60W30/12 |
| Y | * the whole document * ----- | 4,5 | |
| Y | US 2016/253566 A1 (STEIN GIDEON [IL] ET AL) 1 September 2016 (2016-09-01) * paragraphs [0020], [0063], [0069] * * figure 1 * ----- | 4 | |
| Y | GOLDBECK J ET AL: "Lane detection and tracking by video sensors", INTELLIGENT TRANSPORTATION SYSTEMS, 1999. PROCEEDINGS. 1999 IEEE/IEEJ/ JSAI INTERNATIONAL CONFERENCE ON TOKYO, JAPAN 5-8 OCT. 1999, PISCATAWAY, NJ, USA,IEEE, US, 5 October 1999 (1999-10-05), pages 74-79, XP010369840, DOI: 10.1109/ITSC.1999.821030 ISBN: 978-0-7803-4975-9 * Sect. 3, Sect. 8 * ----- | 5 | TECHNICAL FIELDS SEARCHED (IPC) G06K G01S B60W |

-/--

The present search report has been drawn up for all claims

| Place of search | Date of completion of the search | Examiner |
|---|---|---|
| The Hague | 8 January 2018 | Hermes, Lothar |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 17 18 7303

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BISHENG YANG ET AL: "Automated Extraction of Road Markings from Mobile Lidar Point Clouds", PHOTOGRAMMETRIC ENGINEERING AND REMOTE SENSING, vol. 78, no. 4, April 2012 (2012-04), pages 331-338, XP55438258, US ISSN: 0099-1112, DOI: 10.14358/PERS.78.4.331 * abstract * | 2 | |
| A | BLANE M M ET AL: "THE 3L ALGORITHM FOR FITTING IMPLICIT POLYNOMIAL CURVES AND SURFACES TO DATA", IEEE TRANSACTIONS ON PATTERN ANALYSIS AND MACHINE INTELLIGENCE, IEEE COMPUTER SOCIETY, USA, vol. 22, no. 3, March 2000 (2000-03), pages 298-313, XP000928635, ISSN: 0162-8828, DOI: 10.1109/34.841760 * page 298 * | 3,4 | |

TECHNICAL FIELDS
SEARCHED (IPC)

The present search report has been drawn up for all claims

| Place of search | Date of completion of the search | Examiner |
|---|---|---|
| The Hague | 8 January 2018 | Hermes, Lothar |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 18 7303

This annex lists the patent family members relating to the patent documents cited in the above-mentioned European search report.
The members are as contained in the European Patent Office EDP file on
The European Patent Office is in no way liable for these particulars which are merely given for the purpose of information.

08-01-2018

| Patent document cited in search report | Publication date | Patent family member(s) | Publication date |
|---|---|---|---|
| US 2016253566 A1 | 01-09-2016 | EP 3262566 A2 <br> US 2016253566 A1 <br> WO 2016135736 A2 | 03-01-2018 <br> 01-09-2016 <br> 01-09-2016 |

EPO FORM P0459

For more details about this annex : see Official Journal of the European Patent Office, No. 12/82